**Europäisches Patentamt**

**European Patent Office**

**Office européen des brevets**

(19)

(11) Veröffentlichungsnummer : **0 429 695 B1**

## (12) EUROPÄISCHE PATENTSCHRIFT

(45) Veröffentlichungstag der Patentschrift :
**11.11.92 Patentblatt 92/46**

(21) Anmeldenummer : **89121923.0**

(22) Anmeldetag : **28.11.89**

(51) Int. Cl.⁵ : **B60R 16/02, H05K 9/00**

(54) **Steuergerät, insbesondere zur Steuerung von Funktionen eines Kraftfahrzeugs.**

(43) Veröffentlichungstag der Anmeldung :
**05.06.91 Patentblatt 91/23**

(45) Bekanntmachung des Hinweises auf die
Patenterteilung :
**11.11.92 Patentblatt 92/46**

(84) Benannte Vertragsstaaten :
**DE FR GB IT**

(56) Entgegenhaltungen :
**DE-A- 2 409 660**
**DE-U- 8 715 073**

(56) Entgegenhaltungen :
**US-A- 4 668 873**
**MACHINE DESIGN. vol. 56, no. 20, 06 September 1984, CLEVELAND US Seiten 144 - 146;
WILLIAMSON: "MINIMIZING NOISE IN DIGITALPCB LAYOUTS"**

(73) Patentinhaber : **SIEMENS
AKTIENGESELLSCHAFT
Wittelsbacherplatz 2
W-8000 München 2 (DE)**

(72) Erfinder : **Fisch, Alfons, Dipl.-Ing. (FH)
Litzelsdorf 4
W-8411 Falkenstein (DE)**

EP 0 429 695 B1

## Beschreibung

Die Erfindung geht aus von einem Steuergerät wie es in dem deutschen Gebrauchsmuster 87 15 073 beschrieben ist.

Ein solches Steuergerät hat einen Analogteil mit analogen Bausteinen und einen Digitalteil mit Digitalbausteinen, die auf einer Tragplatte angeordnet sind, die auf der Oberseite "gedruckte" Verbindungsleitungen für die Bausteine, Anschlußkontakte zum Anschluß von Signalleitungen und Masseanschlußpunkte aufweist. Auf der Unterseite der Tragplatte ist eine flächenhafte Masseschicht angeordnet, mit der die Masseanschlußpunkte auf der Oberseite auf kürzestem Weg verbunden sind; hierzu dienen Verbindern, die durch Löcher in der Tragplatte hindurchgehen, wodurch sich sehr niederohmige Masseverbindungen ergeben.

Trotz dieses vorteilhaften Aufbaus wurde bei solchen Steuergeräten eine Hochfrequenzabstrahlung gemessen, die in manchen Fällen stört. Dies ist vor allem dann der Fall, wenn aus dem Steuergerät führende Leitungen, insbesondere die Masseleitung, mit weiteren Leitungen, die zu anderen elektronischen Geräten führen, einen Kabelbaum bilden: Hierbei entsteht eine sehr enge Kopplung zwischen mehreren Geräten, die zur gegenseitigen Störung führen kann. Der Erfindung liegt die Aufgabe zugrunde, ein Steuergerät so aufzubauen, daß die Störstrahlung weiter reduziert wird.

Die Erfindung ist in Patentanspruch 1 gekennzeichnet. Sie besteht im wesentlichen in dem Vorschlag, wenigstens zwei Plattenteile mit elektrisch voneinander isolierten flächenhaften Massen, einer Analogmasse und einer Digitalmasse, vorzusehen und auf dem Plattenteil mit der Digitalmasse alle "schnellen" Digitalbauteile des Steuergerätes, z. B. Prozessor und Speicher, anzuordnen, die durch die Verarbeitung von Signalen mit steilen Signalflanken (<1 μsec pro Flanke) und/oder mit hoher Taktfrequenz (> 500 kHz) gekennzeichnet sind. Dem Analogteil mit Signalleitung und ihrer Abschirmung ist eine davon getrennte Analogmasse zugeordnet. Die Analogmasse und die Digitalmasse sind dann räumlich getrennt voneinander mit der elektrisch leitenden Grundplatte des Steuergeräts verbunden, andie auch die von außen kommende Masseleitung angeschlossen wird.

Die Erfindung beruht auf der Feststellung, daß sich bei der bekannten Technik ein hochfrequenter Potentialunterschied zwischen der Grundplatte einerseits und der flächenhaften Masse und den damit elektrisch verbundenen Teilen - Masseanschlußleitung, Signalschirm - ausbildet, der über diese Leitungen abgestrahlt wird. Als Ursache für diese Störspannung wurden die Impulsströme im Digitalteil, z.B. zwischen einem Mikroprozessor und einem Speicher (EPROM), ermittelt: Diese Impulsströme haben sehr hochfrequente Anteile, die bereits in kurzen Masseanschlußleitungen und in der Grundplatte - wegen der geringen Eindringtiefe - störende Spannungsabfälle erzeugen. Durch die erfindungsgemäße Abtrennung einer separaten Digitalmasse von der Analogmasse des Analogteils läßt sich die Störabstrahlung drastisch reduzieren, da zwischen den beiden Massen praktisch keine hochfrequente Kopplung mehr besteht.

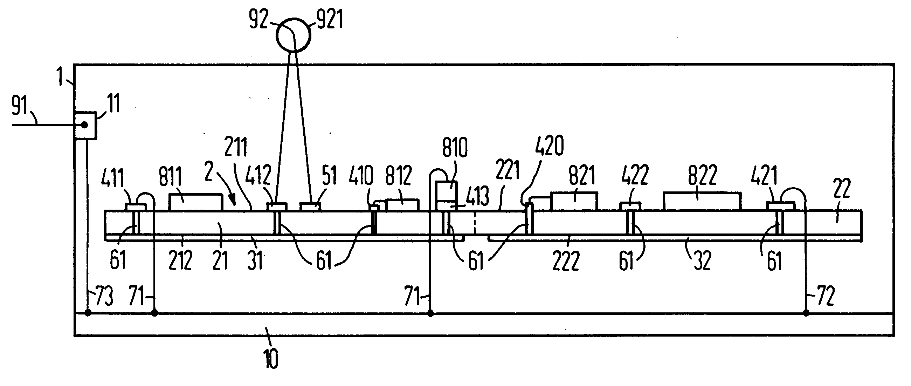

Im Rahmen der Erfindung kann das Plattenteil mit der Digitalmasse eine gesonderte Tragplatte zu bilden, die auf ihrer Oberseite die Digitalbausteine trägt. Meist ist es jedoch vorteilhafter, wenn die beiden Plattenteile eine einstückige Tragplatte bilden, auf deren Unterseite nebeneinander die Analogmasse und die Digitalmasse elektrisch voneinander getrennt angeordnet sind. Ein Ausführungsbeispiel dieser Art wird anhand der Figur näher beschrieben, die einen Querschnitt durch ein Steuergerät 1 - z. B. ein Zündsteuergerät - mit einer elektrisch leitenden Grundplatte 10 in schematisierter Form zeigt. Eine einstückige Tragplatte 2, z.B. ein Keramiksubstrat, ist in zwei Teilbereiche gegliedert, nämlich ein Plattenteil 21 und ein Plattenteil 22, deren Oberseiten mit 211 bzw. 221 und deren Unterseiten mit 212 bzw. 222 bezeichnet sind.

Auf der Oberseite 211 des Plattenteils 21 sind überwiegend analoge Eingangsbausteine 811, 812 des Analogteils (keine "schnellen" Digitalbausteine), eine gedruckte Schaltung, (nicht dargestellt) zur Verbindung der Eingangsbausteine untereinander und mit einem Anschlußkontakt 51 und mit Masseanschlußpunkten 410 bis 413 angeordnet. Alle Masseanschlußpunkte sind über Verbinder 61 - durch Löcher in dem Plattenteil 21 geführt - mit der Analogmasse 31 auf der Unserseite 212 des Plattenteils 21 verbunden.

Eine Signalleitung 92 - z. B. von einem Drehsensor kommend - ist mit dem Anschlußkontakt 51 und ihr Schirm 921 mit dem Masseanschlußpunkt 412 verbunden. Der Masseanschlußpunkt 410 ermöglicht beispielsweise einen kurzen Masseanschluß des Bausteins 812.

Das Plattenteil 22 hat auf seiner Unterseite 222 eine flächenhafte Masse - Digitalmasse 32. Auf der Oberseite 221 sind alle "schnellen" Digitalbausteine 821, 822 des Steuergerätes - z. B. ein Mikroprozessor und mindestens ein peripherer Digitalbaustein, z. B. ein EMPROM - angeordnet und durch nicht dargestellte gedruckte Schaltungen - Adreß- und Datenbus - miteinander verbunden. Zur Verbindung der Digitalmasse 32 mit Masseanschlußpunkten 420 bis 422 auf der Oberseite 221 dienen auch hier Verbinder 61 in Löchern des Plattenteils 22. Der Masseanschlußpunkt 420 ermöglicht eine kurze Verbindung des Bausteins 821 oder eines Punktes einer gedruckten Schaltung mit der Digitalmasse 32.

Die Analogmasse 31 ist an wenigstens einer Stelle über einen Masseanschlußpunkt 411 und eine Verbindungsleitung 71 - Bonddraht - und die Digitalmasse 32 über einen Masseanschlußpunkt 421 und eine Verbindungsleitung 72 gleichstromleitend mit unterschiedlichen Punkten der elektrisch leitenden Grundplatte 10 verbunden. Von dieser führt eine Verbindungsleitung 73 zu einer Masseklemme 11 zum Anschluß einer Masseleitung 91. Die Höhe der zwischen Grundplatte 10 - Masseleitung 91 - und Analogmasse 31 - Schirm 921 - wirksamen Reststörspannung ist von der Anzahl der Verbindungen zwischen Grundplatte 10 und Analogmasse 31 abhängig. Besonders gute Ergebnisse sind zu erzielen, wenn diese Analogmasse in mehrere Flächenbereiche unterteilt ist, von denen jeder über einen zugehörigen Masseanschlußpunkt und eine Verbindungsleitung an den nächstliegenden Anschlußpunkt der Grundplatte 10 angeschlossen ist. Dabei ist es meist zweckmäßig, nur eine Verbindung gleichstromleitend und die anderen kapazitiv auszubilden. So ist z. B. in der Figur zwischen dem Masseanschlußpunkt 413 und der Verbindungsleitung 71 ein Kondensator 810 mit 22 µF eingelötet. Solche Kondesatoren verhindern dabei Störungen durch eine räumliche Verteilung von Gleichströmen einer Leistungsstufe - z. B. der Zündendstufe - auf dem Eingangsteil.

Abweichend vom beschriebenen Ausführungsbeispiel kann der Digitalteil auch auf zwei Teilplatten mit zugeordneten Digitalmassen verteilt sein; ein Plattenteil kann dabei mit dem dem Analogteil zugeordneten Plattenteil eine einstückige Tragplatte bilden, die auf der Unterseite zwei von einander isolierte Masseflächen - Analog- und Digitalmasse - hat.

Die Tragplatte oder Plattenteile sind vorzugsweise mit der Grundplatte 10 durch Klebstoff befestigt.

## Patentansprüche

1. Steuergerät (1) insbesondere zur Steuerung von Funktionen eines Kraftfahrzeugs,
    - mit einem Analogteil zur Aufbereitung eines Eingangssignals,
        -- mit einem ersten Plattenteil (21) mit Oberseite (211) und Unterseite (212), das
            --- auf der Unterseite (212) eine flächenhafte Teilmasse - Analogmasse (31) - und das
            --- auf der Oberseite (211) analoge Eingangsbausteine (811, 812), gedruckte Verbindungsleitungen, einen Anschlußkontakt (51) für eine Signalleitung (92), Masseanschlußpunkte (410 bis 413), die mit der Anlogmasse (31) durch Löcher in dem Plattenteil (21) auf kürzestem Wege verbunden sind, insbesondere zum Anschluß eines Schirmes (921) der Signalleitung (92), aufweist;
    - mit einem Digitalteil zur Gewinnung eines Steuersignals aus dem Eingangssignal,
    -- mit mindestens einem Plattenteil (22) mit Oberseite (221) und Unterseite (222), das
        --- auf seiner Unterseite (222) eine flächenhafte Masseschicht - Digitalmasse (32) - hat und das
        --- auf seiner Oberseite (221) Digitalbausteine (821, 822) mit einem Mikroprozessor und mindestens einem peripheren Digitalbaustein sowie gedruckte Verbindungsleitungen, die einen Daten- und Adreßbus einschließen, und Massenanschlußpunkte (420 bis 422), die durch Löcher in dem Plattenteil (22) auf kürzestem Wege mit der Digitalmasse (32) verbunden sind, aufweist;
    - mit einer elektrische leitenden Grundplatte (10), die die Plattenteile (21, 22) trägt, und mit der mindestens ein Masseanschlußpunkt (411) des Analogteils und räumlich davon getrennt ein Masseanschlußpunkt (421) des Digitalteils sowie eine Masseklemme (11) zum Anschluß einer Masseleitung (91) verbunden sind.

2. Steuergerät nach Anspruch 1,
    **dadurch gekennzeichnet,**
    daß die Plattenteile (21, 22) von Analogteil und Digitalteil eine einstückige Tragplatte (2) mit voneinander getrennter flächenhafter Analog und Digitalmasse (31, 32) bilden.

3. Steuergerät nach Anspruch 1,
    **dadurch gekennzeichnet,**
    daß das Plattenteil (21) des Analogteils mehrere räumlich voneinander entfernte Masseanschlußpunkte hat, die auf kürzestem Wege mit der Tragplatte (10) verbunden sind, wobei mindestens eine dieser Verbindungen gleichstromleitend und mindestens eine weitere Verbindung kapazitiv ausgebildet ist.

## Claims

1. Control apparatus (1), particularly for controlling functions of a motor vehicle,
    - having an analog part for preprocessing an input signal,
        -- having a first plate part (21) with an upper side (211) and a lower side (212), which
            --- has on the underside (212) a planar sub-ground layer - analog ground (31) - and which
            --- has on the upper side (211) analog input modules (811, 812), printed connecting lines, a terminal contact (51) for a signal line (92), grounding terminal points (410 to 413) which are connected to the analog ground (31) through holes in the plate part (21) over the shortest possible path, particularly, in order to connect a shield (921) of the signal line (92);

- having a digital part for acquiring a control signal from the input signal,

-- having at least one plate part (22) with upper side (221) and underside (222) which

--- has on its underside (222) a planar grounding layer - digital ground (32) - and which

--- has on its upper side (221) digital modules (821, 822) with a microprocessor and at least one peripheral digital module as well as printed connecting lines which include a data and address bus, and grounding terminal points (420 to 422) which are connected to the digital ground (32) through holes in the plate part (22) over the shortest possible path;

- having an electrically conductive base part (10) which bears the plate part (21, 22) and to which at least one grounding terminal point (411) of the analog part is connected, and spatially separated therefrom a grounding terminal point (421) of the digital part and a grounding terminal (11) are connected in order to connect a grounding line (91).

2. Control apparatus according to Claim 1, characterised in that the plate part (21, 22) of the analog part and digital part form a one-piece carrying plate (2) with planar analog and digital ground (31, 32) separated from one another.

3. Control apparatus according to Claim 1, characterised in that the plate part (21) of the analog part has a plurality of grounding terminal points which are spatially distant from one another and are connected to the carrying plate (10) over the shortest possible path, at least one of these connections conducts direct current and at least one further connection is capacitive.

**Revendications**

1. Dispositif de commande (1) notamment pour la commande de fonctions d'un véhicule automobile, comportant

- une partie analogique pour la préparation d'un signal d'entrée,

-- un premier élément en forme de plaque (21) possédant une face supérieure (211) et une face inférieure (212), et qui possède,

--- sur la face inférieure (212), une masse partielle-masse analogique (31) d'une certaine étendue en surface - et

--- sur la face supérieure (211), des modules d'entrée analogiques (811, 812), des conducteurs de liaison imprimés, un contact de raccordement (51) pour une ligne de transmission de signaux (92), des points de raccordement à la masse (410 à 413), qui sont reliés selon le trajet le plus court à la masse analogique (31) par des trous ménagés dans l'élément en forme de plaque (21), notamment pour le raccordement d'un blindage (921) de la ligne de transmission de signaux (92);

- une partie numérique servant à former un signal de commande à partir du signal d'entrée,

-- au moins un élément en forme de plaque (22) possédant une face supérieure (221) et une face inférieure (222) et qui comporte

--- sur sa face inférieure (222), une couche de masse - masse numérique (32) possédant une certaine étendue en surface, - et

--- sur sa face supérieure (221), des modules numériques (821,822) comportant un microprocesseur et au moins un module numérique périphérique ainsi que des conducteurs de liaison imprimés, qui incluent un bus de transmission de données et un bus de transmission d'adresses, et des points (420 à 422) de raccordement à la masse, qui sont raccordés selon le trajet le plus court à la masse numérique (32) par l'intermédiaire de trous ménagés dans l'élément en forme de plaque (22);

- une plaque de base électriquement conductrice (10), qui porte des éléments en forme de plaques (21,22) et à laquelle sont raccordés au moins un point de raccordement à la masse (411) de la partie analogique et, d'une manière séparée de ce point dans l'espace, un point de raccordement à la masse (421) de la partie numérique ainsi qu'une borne de masse (11) pour le raccordement d'un conducteur de masse (91).

2. Dispositif de commande suivant la revendication 1, caractérisé par le fait que les éléments en forme de plaques (21,22) de la partie analogique et de la partie numérique forment une plaque de support monobloc (2) comportant une masse analogique et une masse numérique (31,32), qui possèdent une certaine étendue en surface et sont séparées l'une de l'autre.

3. Dispositif de commande suivant la revendication 1, caractérisé par le fait que l'élément en forme de plaque (21) de la partie analogique possède plusieurs points de raccordement à la masse, qui sont éloignés spatialement les uns des autres et sont raccordés par le trajet le plus court à la plaque de support (10), au moins l'une de ces liaisons étant réalisées de manière à conduire le courant continu et au moins une autre liaison étant agencée sous forme capacitive.